# EUROPEAN PATENT SPECIFICATION

(11) **EP 1 783 907 B1**
(45) Date of publication and mention of the grant of the patent: **16.12.2009**
(21) Application number: 06017187.3
(22) Date of filing: 17.08.2006
(51) Int. Cl.: H03J 3/06, H03F 1/02

(54) **Low noise, high linearity TV tuner architecture with switched fixed-gain LNA**
Rauscharme Fernsehtunerarchitektur mit hoher Linearität und geschaltetem LNA mit fest eingestellter Verstärkung
Architecture de syntoniseur de télévision à faible bruit et à haute linéarité, avec amplificateur commuté à faible bruit et à gain fixe

(30) Priority: 08.11.2005 US 597066 P
(43) Date of publication of application: 09.05.2007
(73) Proprietor: Quantek, Inc., Sindian City Taipei Hsien (TW)
(72) Inventor: Tseng, Chao-Wen, Baoshan Hsiang Hsin-Chu Hsien Taiwan (CN); Lau, Wai, Hsindian City Taipei Hsien Taiwan (CN)
(74) Representative: Görz, Ingo

(56) References cited:
- EP-A2- 0 678 981
- WO-A-99/30426
- WO-A2-02/093732
- DE-A1- 19 839 857

## Description

The present invention relates to a TV tuner according to the pre-characterizing clause of claim 1. Such a TV tuner is known from WO 99/30426 A1.

TV tuners are used in a variety of consumer and commercial systems such as TVs, VCRs, and more sophisticated devices that include cable modems and cable set-top-boxes. A TV tuner is responsible for receiving all available channels, selecting the desired channel and filtering out the others.

World Intellectual Property Organization publication WO 02/093732, describes a state-of-the art integrated TV tuner. This type of TV tuner uses double conversion, and thus includes two polyphase filters and two mixers.

Another example of an integrated TV tuner is one that has been developed by PHILLIPS. The TDA8275 silicon IC tuner provides a low intermediate frequency (IF) signal to a subsequent decoder device, but relies on proprietary architecture to do so. That is, commonly available decoders or demodulators cannot be used with the TDA8275.

A wideband receiver, such as terrestrial digital TV (DVB-T), requires high linearity and low noise. It is also necessary to have a wide continuous gain range to maximize a signal-to-noise-and-distortion-ratio (SNDR) at tuner output. Typically a low-noise amplifier (LNA) with a wide tuning range is employed to simultaneously satisfy three requirements: high linearity, low noise, and wide tuning range. However, performance is compromised by trading off sensitivity and largest signal that can be handled, and often at the expense of high power consumption.

This in mind, the present invention aims at providing a further low noise, high linearity TV tuner architecture with switched fixed-gain LNA.

This is achieved by a TV tuner according to claim 1. The dependent claims pertain to corresponding further developments and improvements.

As will be seen more clearly from the detailed description following below, the claimed TV tuner is utilized for achieving a low noise, high linearity TV tuner architecture with switched fixed-gain LNA.

In the following, the invention is further illustrated by way of example, taking reference to the accompanying drawings. Thereof:
Fig. 1 is a block diagram of a TV tuner according to the present invention, and
Fig. 2 is a block diagram of another TV tuner according to the present invention.

The present invention uses a bank of fixed gain low-noise amplifiers (LNAs), followed by a wide continuous gain range intermediate frequency (IF) amplifier. By using more than one fixed gain LNA, noise figure and linearity can be better traded off. For example, a maximum gain LNA can be optimized for minimum noise figure while a minimum gain LNA can be optimized for high linearity. A wide tuning range IF amplifier ensures the overall transfer function has continuous gain.

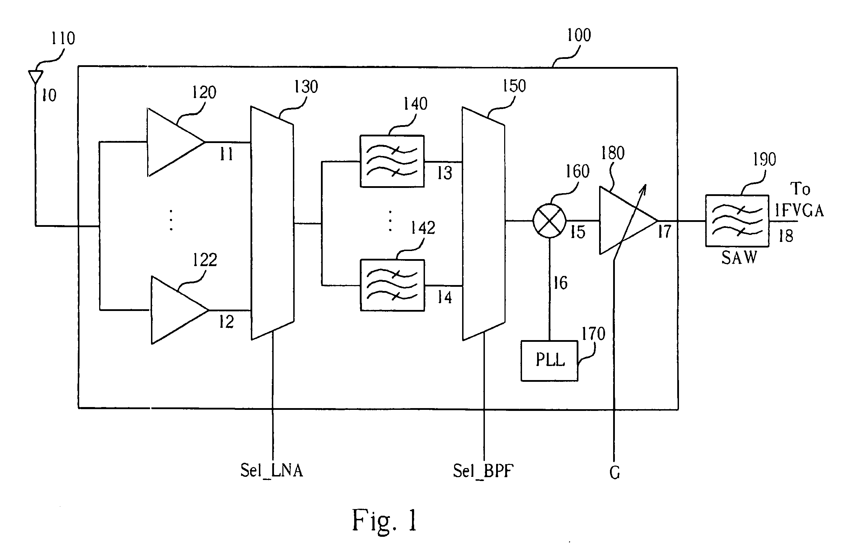

Please refer to Fig. 1. Fig. 1 shows a TV tuner 100 according to the present invention. The TV tuner 100 comprises a plurality of amplifiers 120-122 having inputs coupled to an external antenna 110, a multiplexer 130 (second multiplexer) having inputs coupled to outputs of the amplifiers 120-122, a plurality of filters 140-142 having inputs coupled to an output of the multiplexer 130, another multiplexer 150 (first multiplexer) having inputs coupled to outputs of the plurality of filters 140-142, a mixer 160 having an input coupled to an output of first multiplexer 150, and an output amplifier 180 having an input coupled to an output of the mixer 160 and an output for providing output of the TV tuner 100. A phase-locked loop (PLL) 170 is also provided and connected to the mixer 160. The output of the TV tuner 100 can be connected to an external surface acoustic wave (SAW) filter 190, for example.

The amplifiers 120-122 can be fixed-gain low-noise amplifiers. There can be two or more amplifiers 120-122. Each amplifier can have a different fixed gain spanning a required "discrete" gain range. A higher gain amplifier can be optimized for lower noise figure while a lower gain amplifier can optimized for higher linearity. The overall system noise figure is limited by the maximum gain amplifier while the overall system linearity is limited by the minimum gain amplifier.

At the multiplexer 130, an output of one of the amplifiers 120-122 is selected by a digital signal Sel_LNA, and the selected output is fed to the bank of filters 140-142. The multiplexer 130 can be any known digital switching device.

The filters 140-142 can be band-pass filters. There can be one or more band-pass filters 140-142 in the bank. More band-pass filters 140-142 reduce signal bandwidth for the subsequent stages and relieve their linearity requirements. However, this is done at the expense of circuit complexity, area, and power consumption. Lastly, the filters 140-142 can be composed of on-chip and off-chip components. For example, transistors can be put on chip, while passive components, such as resistances and capacitances, can be put off chip. This can allow for better Q values.

At the multiplexer 150, an output of one of the filters 140-142 is selected by a digital signal Sel_BPF, and the selected output is fed to the mixer 160. The digital signal Sel_BPF can be the same as the digital signal Sel_LNA or can be different, i.e., independent. The multiplexer 150 can be any known digital switching device.

The mixer 160 receives the output of the selected band-pass filter 140-142. The mixer 160 can be a single mixer, in the case of direct conversion, or more than one mixer for more frequency conversion. The mixer 160 converts the band-pass filter output to a final intermediate frequency with a local oscillator (LO) signal from a frequency synthesizer, which in this case is the PLL 170. The mixer 160 can be a regular mixer, an image rejection mixer (I-Q mixer), or a harmonic rejection mixer. In addition, the mixer 160 can be configured as a harmonic rejection mixer when certain filters 140-142 are selected, and can be configured as an image rejection mixer when other filters 140-142 are selected. Generally, lower frequency range filters would require a harmonic rejection mixer, while higher range filters would require an image rejection mixer. In regard to this, the mixer 160 can be set up to receive the selection signal Sel_BPF.

The output amplifier 180, or IF amplifier, receives the output of the mixer 160. The output amplifier 180 drives the external SAW filter 190. The output amplifier 180 has a wide continuous gain range, and a gain controlled by an input signal G. The gain range can be chosen to cover the maximum gain step in the bank of fixed-gain low-noise amplifiers 120-122. The continuous gain range facilitates a continuous time control scheme which can be done on-chip. Alternatively, the TV tuner 100 gain can be controlled by a connected demodulation chip.

In operation, the signals of the TV tuner 100 are as follows. The antenna 110 feeds a received signal 10 to the bank of fixed-gain low-noise amplifiers 120-122. Each amplifier 120-122 outputs a corresponding signal I1, I2 to the multiplexer 130. The output of the multiplexer 130, selected according to the selection signal Sel_LNA, is filtered by the bank of band-pass filters 140-142 to form respective signals I3, I4, of which one is selected by the multiplexer 150, by way of the selection signal Sel_BPF, to be input to the mixer 160 and further to be output as a signal I5. At the same time, the mixer 160 also receives a LO signal I6 from the PLL 170. Lastly, the signal I5 is amplified by the output IF amplifier 180 before finally being filtered by the external SAW filter 190 to generate a signal I8.

In one embodiment of the TV tuner 100, a total quantity of amplifiers 120-122 and a total quantity of filters 140-142 is identical. The amplifiers 120-122 correspond to the filters 140-142 in a one-to-one manner. Therefore, the digital signal Sel_BPF is identical to the digital signal Sel_LNA.

In another embodiment, the digital signals Sel_BPF and Sel_LNA are independent from each other. In some applications or circumstances, it may be desirable to be able to arbitrarily match amplifiers 120-122 and filters 140-142.

It should also be mentioned, that unselected amplifiers and filters, that is, amplifiers and filters not selected by the digital signals Sel_BPF and Sel_LNA, can be temporality shut down to save power.

In practical application, there may be four filters 140-142. Each of these four filters may have a different frequency range, such as 50-150 MHz, 150-300 MHz, 300-600 MHz, and 600+ MHz.

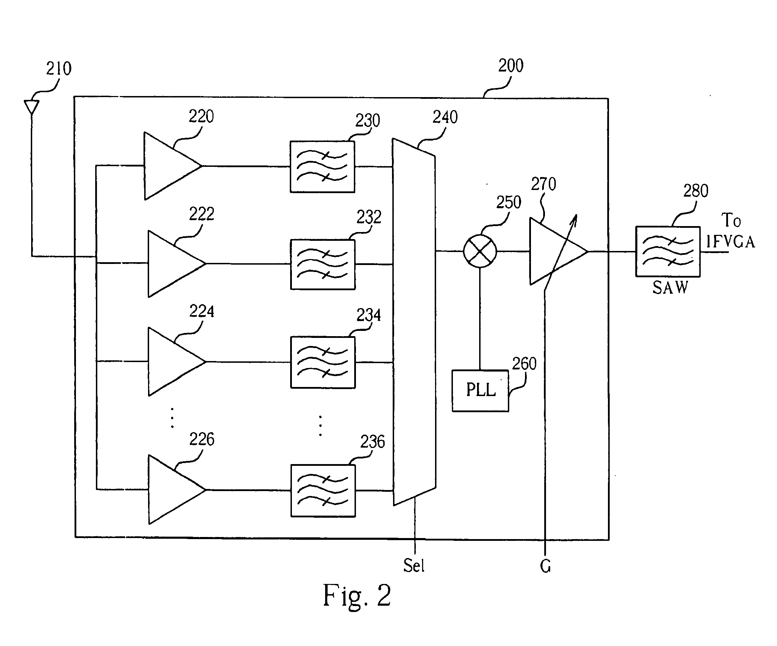

Please refer to Fig. 2. Fig. 2 illustrates another TV tuner 200 according to the present invention. The TV tuner 200 comprises a plurality of amplifiers 220-226 having inputs coupled to an external antenna 210 and a plurality of filters 230-236, each having an input coupled to an output of a different amplifier 220-226 (one-to-one connection). The TV tuner 200 further comprises a multiplexer 240 (first multiplexer) having inputs coupled to outputs of the filters 230-236, a mixer 250 having an input coupled to an output of the multiplexer 240, a PLL 260 coupled to the mixer 250, and an output amplifier 270 having an input coupled to an output of the mixer 250 and an output for providing output of the TV tuner 200. The output of the TV tuner 200 can be connected to an external SAW filter 280, for example.

The elements of the TV tuner 200 are substantially the same as the like-named elements of the TV tuner 100, and redundant description is omitted. However, one key difference is that one selection signal Sel is required since only one multiplexer is used. In this regard, the TV tuner 200 is less flexible than the TV tuner 100, while having the advantage of requiring fewer components. In general, the other above-described provisions for the TV tuner 100 also apply to the TV tuner 200.

Lastly, it should be noted that the specific quantities of amplifiers and filters shown in Fig. 1 and Fig. 2 are merely examples. More or fewer can be used depending on specific requirements.

## Claims

1. A TV tuner (100,200) comprising:
a plurality of amplifiers (120,122,220,222,224,226) comprising inputs for coupling to an antenna (110,210);
a plurality of filters (140,142,230,232,234,236) comprising inputs coupled to outputs of the plurality of amplifiers (120,122,220,222,224,226);
a first multiplexer (150,240) comprising inputs coupled to outputs of the plurality of filters (140,142,230,232,234,236), the first multiplexer (150,240) for selecting an output of one of the filters (140,142,230,232,234,236);
a mixer (160,250) comprising an input coupled to an output of the first multiplexer (150,240); and
an output amplifier (180,270) having an input coupled to an output of the mixer (160,250) and an output for providing output of the TV tuner (100,200),
**characterized by**
a second multiplexer (130) coupled between the plurality of amplifiers (120,122) and the plurality of filters (140,142), inputs of the second multiplexer (130) coupled to the outputs of the plurality of amplifiers (120,122), an output of the second multiplexer (130) coupled to the inputs of the filters (140,142), the second multiplexer (130) for selectively coupling an output of one of the amplifiers (120,122) to all inputs of the filters (140,142).

2. The TV tuner (100) of claim 1, **characterized in that** selection inputs (Sel_LNA, Sel_BPF) of the first and second multiplexers (150,130) are coupled to a same selection signal.

3. The TV tuner (100) of claim 1, **characterized in that** selection inputs (Sel_LNA, Sel_BPF) of the first and second multiplexers (150,130) are coupled to different selection signals.

4. The TV tuner (100,200) of claim 1, **characterized in that** each of the amplifiers (120,122,220,222,224,226) has an output coupled to an input of a different filter (140,142,230,232,234,236).

5. The TV tuner (100,200) of claim 1, **characterized in that** a total quantity of amplifiers (120,122,220,222,224,226) and a total quantity of filters (140,142,230,232,234,236) is identical.

6. The TV tuner (100,200) of claim 1, **characterized in that** the amplifiers (120,122,230,232,234,236) are low-noise amplifiers.

7. The TV tuner (100,200) of claim 6, **characterized in that** the amplifiers (120,122,220,222,224,226) are fixed-gain amplifiers.

8. The TV tuner (100,200) of claim 1, **characterized in that** each amplifier (120,122,220,222,224,226) has a different fixed gain spanning a discrete gain range.

9. The TV tuner (100,200) of claim 1, **characterized in that** the filters (140,142,230,232,234,236) are band-pass filters.

10. The TV tuner (100,200) of claim 1, **characterized in that** the mixer (160,250) is configured as a harmonic rejection mixer or as an image rejection mixer depending on the filter output selected by the first multiplexer (150,240).

11. The TV tuner (100,200) of claim 1, **characterized in that** the output amplifier (180,270) is a variable-gain amplifier.

12. The TV tuner (100,200) of claim 1, **characterized in that** the TV tuner (100,200) further comprises a phase-locked loop (170,260) coupled to the mixer (160,250).

13. The TV tuner (100,200) of claim 1, 2, 3 or 10, **characterized in that**:
the plurality of amplifiers is a plurality of fixed-gain low-noise amplifiers (120,122,220,222,224,226), wherein each fixed-gain low-noise amplifier (120,122,220,222,224,226) has a different fixed gain spanning a discrete gain range;
the plurality of filters is a plurality of band-pass filters (140,142,230,232,234,236), a total quantity of band-pass filters (140,142,230,232,234,236) being identical to a total quantity of fixed-gain low-noise amplifiers (120,122,220,222,224,226);
and
the output amplifier is a variable-gain amplifier (180,270);
and **characterized by**
a phase-locked loop (170,260) connected to the mixer (160,250).

14. The TV tuner (100,200) of claim 13, **characterized in that** each of the fixed-gain low-noise amplifiers (120,122,220,222,224,226) has an output exclusively connected to an input of a different band-pass filter (140,142,230,232,234,236).

## Patentansprüche

1. Fernsehtuner (100, 200), umfassend:
eine Vielzahl von Verstärkern (120, 122, 220, 222, 224, 226) mit Eingängen zur Verbindung mit einer Antenne (110, 210);
eine Vielzahl von Filtern (140, 142, 230, 232, 234, 236) mit Eingängen, die mit den Ausgängen der Vielzahl von Verstärkern (120, 122, 220, 222, 224, 226) verbunden sind;
einen ersten Multiplexer (150, 240) mit Eingängen, die mit den Ausgängen der Vielzahl von Filtern (140, 142, 230, 232, 234, 236) verbunden sind, wobei der erste Multiplexer (150, 240) zum Auswählen eines Ausgangs eines der Filter (140, 142, 230, 232, 234, 236) dient;
einen Mischer (160, 250) mit einem Eingang, der mit einem Ausgang des ersten Multiplexers (150, 240) verbunden ist; und
einen Ausgangsverstärker (180, 270) mit einem Eingang, der mit einem Ausgang des Mischers (160, 250) verbunden ist, und einem Ausgang zum Bereitstellen eines Ausgangs des Fernsehtuners (100, 200),
**gekennzeichnet durch**
einen zweiten Multiplexer (130), der zwischen die Vielzahl der Verstärker (120, 122) und die Vielzahl der Filter (140, 142) geschaltet ist,
Eingänge des zweiten Multiplexers (130), die mit den Ausgängen der Vielzahl von Verstärkern (120, 122) verbunden sind,
einen Ausgang des zweiten Multiplexers (130), der mit den Eingängen der Filter (140, 142) verbunden ist,
wobei der zweite Multiplexer (130) zum wahlweisen Verbinden eines Ausgangs eines der Verstärker (120, 122) mit allen Eingängen der Filter (140, 142) dient.

2. Fernsehtuner (100) nach Anspruch 1, **dadurch gekennzeichnet, dass** Auswahleingänge (Sel_LNA, Sel_BPF) des ersten und zweiten Multiplexers (150, 130) mit dem gleichen Auswahlsignal verbunden sind.

3. Fernsehtuner (100) nach Anspruch 1, **dadurch gekennzeichnet, dass** Auswahleingänge (Sel_LNA, Sel_BPF) des ersten und zweiten Multiplexers (150, 130) mit verschiedenen Auswahlsignalen verbunden sind.

4. Fernsehtuner (100, 200) nach Anspruch 1, **dadurch gekennzeichnet, dass** jeder der Verstärker (120, 122, 220, 222, 224, 226) einen Ausgang aufweist, der mit einem Eingang eines anderen Filters (140, 142, 230, 232, 234, 236) verbunden ist.

5. Fernsehtuner (100, 200) nach Anspruch 1, **dadurch gekennzeichnet, dass** eine Gesamtmenge der Verstärker (120, 122, 220, 222, 224, 226) und eine Gesamtmenge der Filter (140, 142, 230, 232, 234, 236) identisch sind.

6. Fernsehtuner (100, 200) nach Anspruch 1, **dadurch gekennzeichnet, dass** die Verstärker (120, 122, 220, 222, 224, 226) rauscharme Verstärker sind.

7. Fernsehtuner (100, 200) nach Anspruch 6, **dadurch gekennzeichnet, dass** die Verstärker (120, 122, 220, 222, 224, 226) Verstärker mit fest eingestellter Verstärkung sind.

8. Fernsehtuner (100, 200) nach Anspruch 1, **dadurch gekennzeichnet, dass** jeder Verstärker (120, 122, 220, 222, 224, 226) eine andere fest eingestellte Verstärkung aufweist, die einen separaten Verstärkungsbereich abdeckt.

9. Fernsehtuner (100, 200) nach Anspruch 1, **dadurch gekennzeichnet, dass** die Filter (140, 142, 230, 232, 234, 236) Bandpassfilter sind.

10. Fernsehtuner (100, 200) nach Anspruch 1, **dadurch gekennzeichnet, dass** der Mischer (160, 250) als ein Obertonaussteuerungsmischer oder als ein Bildaussteuerungsmischer ausgelegt ist, abhängig von dem vom ersten Multiplexer (150, 240) ausgewählten Filterausgang.

11. Fernsehtuner (100, 200) nach Anspruch 1, **dadurch gekennzeichnet, dass** der Ausgangsverstärker (180, 270) ein Verstärker mit variabler Verstärkung ist.

12. Fernsehtuner (100, 200) nach Anspruch 1, **dadurch gekennzeichnet, dass** der Fernsehtuner (100, 200) ferner einen Phasenregelkreis (170, 260), der mit dem Mischer (160, 260) verbunden ist, umfasst.

13. Fernsehtuner (100, 200) nach Anspruch 1, 2, 3 oder 10, **dadurch gekennzeichnet, dass**
die Vielzahl der Verstärker eine Vielzahl von rauscharmen Verstärkern mit fest eingestellter Verstärkung (120, 122, 220, 222, 224, 226) sind, wobei jeder rauscharme Verstärker mit fest eingestellter Verstärkung (120, 122, 220, 222, 224, 226) eine unterschiedliche fest eingestellte Verstärkung aufweist, die einen separaten Verstärkungsbereich abdeckt;
die Vielzahl der Filter eine Vielzahl von Bandpassfiltern (140, 142, 230, 232, 234, 236) ist, wobei eine Gesamtmenge der Bandpassfilter (140, 142, 230, 232, 234, 236) identisch zu einer Gesamtmenge der rauscharmen Verstärker mit fest eingestellter Verstärkung (120, 122, 220, 222, 224, 226) ist; und
der Ausgangsverstärker ein Verstärker mit variabler Verstärkung (170, 270) ist; und **gekennzeichnet durch**
einen Phasenregelkreis (170, 260), der mit dem Mischer (160, 250) verbunden ist.

14. Fernsehtuner (100, 200) nach Anspruch 13, **dadurch gekennzeichnet, dass** jeder der rauscharmen Verstärker mit fest eingestellter Verstärkung (120, 122, 220, 222, 224, 226) einen Ausgang aufweist, der ausschließlich mit einem Eingang eines anderen Bandpassfilters (140, 142, 230, 232, 234, 236) verbunden ist.

## Revendications

1. Tuner de téléviseur (100, 200) comprenant :
une pluralité d'amplificateurs (120, 122, 220, 222, 224, 226) comprenant des entrées pour se coupler à une antenne (110, 210) ;
une pluralité de filtres (140, 142, 230, 232, 234, 236) comprenant des entrées couplées à des sorties de la pluralité d'amplificateurs (120, 122, 220, 222, 224, 226) ;
un premier multiplexeur (150, 240) comprenant des entrées couplées à des sorties de la pluralité de filtres (140, 142, 230, 232, 234, 236), le premier multiplexeur (150,240) étant destiné à sélectionner une sortie de l'un des filtres (140, 142, 230, 232, 234, 236);
un mixeur (160, 250) comprenant une entrée couplée à une sortie du premier multiplexeur (150 240) ; et
un amplificateur de sortie (180, 270) ayant une entrée couplée à une sortie du mixeur (160, 250) et une sortie pour fournir une sortie du tuner de téléviseur (100, 200),
**caractérisé par**
un deuxième multiplexeur (130) couplé entre la pluralité d'amplificateurs (120, 122) et la pluralité de filtres (140, 142), les entrées du deuxième multiplexeur (130) étant couplées aux sorties de la pluralité d'amplificateurs (120, 122), une sortie du deuxième multiplexeur (130) étant couplée aux entrées des filtres (140, 142), le deuxième multiplexeur (130) étant destiné à coupler sélectivement une sortie de l'un des amplificateurs (120, 122) à toutes les entrées des filtres (140, 142).

2. Tuner de téléviseur (100) selon la revendication 1, **caractérisé en ce que** les entrées de sélection (Sel_LNA, Sel_BPF) des premier et deuxième multiplexeurs (150, 130) sont couplées à un même signal de sélection.

3. Tuner de téléviseur (100) selon la revendication 1, **caractérisé en ce que** les entrées de sélection (Sel_LNA, Sel_BPF) des premier et deuxième multiplexeurs (150, 130) sont couplées à des signaux de sélection différents.

4. Tuner de téléviseur (100, 200) selon la revendication 1, **caractérisé en ce que** chacun des amplificateurs (120, 122, 220, 222, 224, 226) a une sortie couplée à une entrée d'un filtre différent (140, 142, 230, 232, 234, 236).

5. Tuner de téléviseur (100, 200) selon la revendication 1, **caractérisé en ce qu'**une quantité totale d'amplificateurs (120, 122, 220, 222, 224, 226) et une quantité totale de filtres (140, 142, 230, 232, 234, 236) sont identiques.

6. Tuner de téléviseur (100, 200) selon la revendication 1, **caractérisé en ce que** les amplificateurs (120, 122, 220, 222, 224, 226) sont des amplificateurs à faible bruit.

7. Tuner de téléviseur (100, 200) selon la revendication 6, **caractérisé en ce que** les amplificateurs (120, 122, 220, 222, 224, 226) sont des amplificateurs à gain fixe.

8. Tuner de téléviseur (100, 200) selon la revendication 1, **caractérisé en ce que** chaque amplificateur (120, 122, 220, 222, 224, 226) a un gain fixe différent couvrant une plage de gains discrète.

9. Tuner de téléviseur (100, 200) selon la revendication 1, **caractérisé en ce que** les filtres (140, 142, 230, 232, 234, 236) sont des filtres passe-bande.

10. Tuner de téléviseur (100, 200) selon la revendication 1, **caractérisé en ce que** le mixeur (160, 250) est configuré en tant que mixeur de rejet d'harmonique ou en tant que mixeur de rejet d'image en fonction de la sortie de filtre sélectionnée par le premier multiplexeur (150, 240).

11. Tuner de téléviseur (100, 200) selon la revendication 1, **caractérisé en ce que** l'amplificateur de sortie (180, 270) est un amplificateur de gain variable.

12. Tuner de téléviseur (100, 200) selon la revendication 1, **caractérisé en ce que** le tuner de téléviseur (100, 200) comprend en outre une boucle à verrouillage de phase (170, 260) couplée au mixeur (160, 250).

13. Tuner de téléviseur (100, 200) selon la revendication 1, 2, 3 ou 10, **caractérisé en ce que**:
la pluralité d'amplificateurs est une pluralité d'amplificateurs à gain fixe et à faible bruit (120, 122, 220, 222, 224, 226), dans lequel chaque amplificateur à gain fixe et à faible bruit (120, 122, 220, 222, 224, 226) a un gain fixe différent couvrant une plage de gains discrète ;
la pluralité de filtres est une pluralité de filtres passe-bande (140, 142, 230, 232, 234, 236), une quantité totale de filtres passe-bande (140, 142, 230, 232, 234, 236) étant égale à une quantité totale d'amplificateurs à gain fixe et à faible bruit (120, 122, 220, 222, 224, 226) ; et
l'amplificateur de sortie est un amplificateur à gain variable (180, 270);
et **caractérisé par**
une boucle à verrouillage de phase (170, 260) connectée au mixeur (160,250).

14. Tuner de téléviseur (100, 200) selon la revendication 13, **caractérisé en ce que** chacun des amplificateurs à gain fixe et à faible bruit (120, 122, 220, 222, 224, 226) a une sortie exclusivement connectée à une entrée d'un filtre passe-bande différent (140, 142, 230, 232, 234, 236).
